# EUROPEAN PATENT APPLICATION

(11) **EP 4 841 672 A1**
(43) Date of publication of application: **18.11.2026**
(21) Application number: 25176991.5
(22) Date of filing: 16.05.2025
(51) Int. Cl.: H01J 37/32, G01L 21/32, G01L 21/34

(54) **ELECTROMAGNETIC OR OPTICAL FEEDTHROUGH**

(71) Applicant: INFICON AG, 9496 Balzers (LI)
(72) Inventor: BRITT, Florian, 8888 Heiligkreuz (CH); WÜEST, Martin, 7208 Malans (CH)
(74) Representative: Troesch Scheidegger Werner AG

(57) **Abstract**

Electromagnetic, in particular optical, feedthrough (10) for guiding electromagnetic radiation, in particular light, out of a processing chamber, wherein said electromagnetic feedthrough comprises a window (11) made of a material transparent to an electromagnetic radiation, in particular transparent to radiation in the optical range, wherein the window has a first side (11') intended to face towards a source of electromagnetic radiation, in particular towards a source of light and a second side (11'') facing away from said first side, wherein on said first side a recess arrangement (12) is formed into the window or a recess arrangement is arranged before the window, said recess arrangement comprising at least one recess (13) with a depth to width ratio larger than 10:1. The invention further relates to a vacuum device with the electromagnetic feedthrough and more specifically to a vacuum pressure sensor comprising the electromagnetic feedthrough. Under a further aspect, the invention relates to a vacuum device, a vacuum pressure sensor and to a sensor arrangement comprising the electromagnetic feedthrough.

## Description

The invention addressed herein relates to the technical field of measuring, in specific aspects it relates to optics. More specifically the invention relates to an electromagnetic feedthrough, in particular to an optical feedthrough. Under further aspects, the invention relates to a vacuum device with the electromagnetic feedthrough or the optical feedthrough and to a vacuum pressure sensor.

For observations of processes in a process chamber, as for example for observation of a plasma in a vacuum process chamber, electromagnetic radiation in the form of light emitted from the process can be guided out of the processing chamber and be analyzed. A window may form a barrier between the region, where the process occurs, and an outside region, where the light is analyzed. The window lets the light through, but, as in the example of a vacuum processing chamber, may form a barrier between a vacuum side and an atmosphere side of processing chamber. Depending on the processes going on, the window may become coated, etched or contaminated over time. Due to such changes on the window, the optical signal received on the sensor side could decrease, be changed in its spectral contribution or, in the worst case, get totally lost, because the window becomes intransparent for the specific wavelengths to be analyzed. To address this issue the windows may be cleaned or replaced, which leads to interruptions in processes and increased cost. Similar problems occur in cases where electromagnetic fields originating in the inside of a processing chamber are measured by a sensor outside the processing chamber. Coating building up during a process may cause intensity loss or even block the electromagnetic field from crossing a feedthrough being originally transparent for the electromagnetic field. Such electromagnetic fields may e.g. be electromagnetic fields oscillating in high frequency range as is used for sustaining a plasma in a plasma processing chamber.

The object of the present invention is to provide a device which reduces or avoids the problems of the state of the art.

This object is achieved by an electromagnetic, in particular optical, feedthrough according to claim 1. The electromagnetic feedthrough according to the invention is a feedthrough for guiding electromagnetic radiation, in particular light, out of a processing chamber. The electromagnetic feedthrough comprises a window made of a material transparent to an electromagnetic radiation, in particular transparent to radiation in the optical range. The window has a first side and a second side facing away from the first side. On said first side a recess arrangement is formed into the window or a recess arrangement is arranged adjacent to the window. The recess arrangement comprises at least one recess with a depth to width ratio larger than 10:1, preferably larger than 20:1. The recess arrangement may comprise a multitude of recesses. In the multitude of recesses, all the recesses may have a depth to width ratio larger than 10:1, preferably larger than 20:1.

The processing chamber may be a vacuum processing chamber and the electromagnetic feedthrough may be vacuum-tight, such that the electromagnetic feedthrough may guide electromagnetic radiation, in particular light, originating on a vacuum side, e.g. in a plasma, to an atmosphere side of the vacuum processing chamber. The first side of the window is intended to face towards a source of electromagnetic radiation, in particular towards a source of light.

The depth to width ratio is an aspect-ratio of the recess. It is defined as the ratio of the depth of the recess and the width of the recess, wherein the width is the smaller of two dimensions oriented perpendicular to the depth. I.e. the recess may also have a dimension of the same size or larger than the depth, as long as its width is small enough, as defined before. The depth is measured along a radiation direction, in particular along the light path direction.

The first side is of the electromagnetic feedthrough is oriented towards the processing side, i.e. towards the source of radiation, in particular towards the source of light, when in use.

The transparent material may for example be quartz glass or sapphire. The material being transparent to electromagnetic radiation may in particular be optically transparent. Optically transparent means that at least in a wavelength region of the electromagnetic spectrum, in the visible spectrum, the infrared spectrum or the ultraviolet spectrum, electromagnetic radiation may pass through the optically transparent material. In a broader scope, the material may at least let through electromagnetic radiation in a Megahertz range or a Gigahertz range. In an even broader scope, the material and the thickness of the material be chosen such that slowly changing electric fields or slowly changing magnetic fields can penetrate through the material, such that they can be measured outside the processing chamber.

In specific applications, the window may be transparent to Terahertz (THz) radiation, an electromagnetic radiation in the frequency range between infrared radiation and microwave radiation. As an example, a sender emitting Terahertz radiation may be placed on the outside of the process chamber, Terahertz radiation may be sent into the process chamber, interact with material involved in the process and may exit from the chamber and be analyzed. Entrance and/or exit of the Terahertz radiation into the process and out of the process chamber may occur through a window having the specific type of recesses as defined by the features of the present invention. Such an application of Terahertz may be used as an example for materials characterization.

The recess arrangement may be formed into the window, such that the window is a monolithic object carrying the recess arrangement and at the same time providing a tight structure. The second side of the window may be free of recesses. The second side may be planar or curved to form a side of a lens. The light enters into the window material at a bottom of a recesses on the first side and exit from the window material on the second side.

In an alternative, the recess arrangement may be arranged before the window. In this case, recesses of the recess arrangement may be formed as through holes while the window still provides a tight structure separating a process chamber from an outside, or more specifically, as discussed in more detail below, separate a vacuum chamber from an atmosphere side. A recess arrangement that is arranged before the window may be made of the same material as the window, or may be made of a different material than the window. In the specific case in which through-holes are formed in the recess arrangement situated before the window, it may not be required that the material into which the recesses of the recess arrangement are formed, is transparent. Depending on the specific use, it may however be advantageous, if the material is non-conducting.

In both cases, i.e. in the case that the recess arrangement is formed into the window or in the case that the recess arrangement is arranged before the window, the recess arrangement has the effect that the part of the feedthrough, where light enters into the transparent material, is protected from being coated or etched. In the case that recesses are formed into the window, it is the bottom part of the recesses that is protected from being coated or etched. In the case that the recess arrangement is arranged before the window, the first side of the window is protected. Material deposited on the electromagnetic feedthrough will be deposited to a large amount on the more protruding structures or on the inners side walls of the recesses. The higher the depth to width ratio, the less material arrives at the bottom region of the recesses or on the first side of the window. When comparing different coating methods, the strongest effect results for physical vapor deposition (PVD), where only a very small percentage of the deposited material enters deeper into a recesses than about five times the width of the recess. For chemical vapor deposition (CVD) the effect is less pronounced than for PVD, but deeper than about 15 to 20 times the width of the recesses, essentially no coating will occur.

Various methods may be applied to produce recess structures with a depth to width ratio as high as 10:1 or 20:1. Drilling holes with small diameter and that do not completely cross the material of the window, or sawing slits by means of a wire saw, which slits do not completely cross the material of the window, may be possible options. For the alternative in which the recess arrangement is arranged before the window, recesses in the form of through holes are acceptable. Methods to form through holes of high aspect ratio are discussed in context of specific embodiments below.

Walls of the recesses may be covered by a thin layer of electrically conductive material. By applying a voltage to these electrically conductive faces, charged particles of a plasma may be pushed away from the surfaces be electrostatic repulsion. This mechanism further improves the protection of the optical feedthrough against a material deposition. A metallization of the walls of the recesses may be realized thin enough to avoid a disturbance of the transmission of light.

In the context of the present invention, a feedthrough is an element that is part of a wall of a process chamber or can be integrated into a wall of a process chamber such that it is, in combination with a wall, able to block a material flow between an interior and exterior of the process chamber. It is an electromagnetic feedthrough, when it lets through electromagnetic fields. It is an optical feedthrough, when it specifically lets through electromagnetic radiation in the optical wavelength range. The blocking of material flow may be such that it fulfills criteria for being gas tight or in specific embodiments, such that it fulfills criteria for being vacuum tight.

The electromagnetic feedthrough according to the present invention may enable a temperature measurement of a process plasma or a processed object inside a processing chamber by a sensor of the pyrometer type arranged outside the processing chamber adjacent to the electromagnetic feedthrough. The electromagnetic feedthrough according to the present invention may be used in context of a process monitoring device, which measures electric or magnetic fields by means of a sensor outside a processing chamber and adjacent to the electromagnetic feedthrough, which lets through fields resulting from currents or charge distributions of a plasma inside the processing chamber. In all these cases, the window of the electromagnetic feedthrough has material deposited on it, which could degrade the quality of the measurement. Due to the recess arrangement, a significant amount of electromagnetic radiation of interest still can get through to the sensor, even after deposition of material on the window.

In an embodiment of the electromagnetic feedthrough, in a view direction from the first side, a percentage of the area of the window covered by said recess arrangement is larger than 50%.

In this embodiment, a relatively large fraction of the window area can be protected from material deposition. Various geometries of the recesses may be applied to achieve such a structure. Examples are recesses, which have in view direction from the first side, the form of concentric rings, an array of circles, e.g. densely packed in a hexagonal array, a spiral shaped recess, etc. Another example would be a surface on which a large number of pillars are arranged, such that single recess or a low number of recesses is formed in between the large number of pillars. The height of the pillars and the distance between the pillars determine the depth to width ratio of the recess. Pillars with very small diameters and distances to each other, e.g. in the nanometer range, may be formed on a surface of the window to achieve the protecting effect.

In an embodiment, the recesses of said recess arrangement are formed by selective laser-induced etching. This embodiment may in particular be combined with the alternative in which the recesses are formed into the window.

Selective laser-induced etching (SLE) is a method of machining structures into a transparent material. Ultrashort pulsed laser irradiation is focused on spots inside a transparent material and leads to very localized heating of the material. By applying high repetition rates and fast movement of the focal spot, high temperature states and high pressure states may be permanently frozen in, such that tracks, faces or volumes of strongly modified material property may be created. The geometry of regions of modified material property may be defined essentially free. The interesting property of this modified region is that they may be etched much easier than the unmodified material. The ratio in etching rate of modified material versus unmodified material is called selectivity. Selectivity values of 100 to 1000 can be achieved for etching of glass by in a KOH solution. When the structure of the modified material has one end on an outer surface of the transparent material, and when this end is brought into contact with an etching solution, the structure of modified material is etched away much quicker than the unmodified material.

Selective laser-induced etching turns out to be a method specifically well suited to produce structures of very high aspect ratio, which structure would be nearly impossible to produce by other methods.

In an embodiment, the recess arrangement is arranged before the window and the recess arrangement is a microchannel plate or an array of glass capillaries.

With this embodiment, a part of the optical feedthrough, which comprises the recess arrangement, may be designed and used as exchange part, such that the total lifetime of the system may be increased further.

A microchannel plate may have the form of a plate, and having large number of microchannels crossing the plate parallel to the smallest dimension of the plate. In this embodiment, the microchannels have the role of the recesses of the recess arrangement. In a variant, the channels may be oriented slightly slanted in relation to a direction perpendicular to the plate. Such an orientation may further reduce the number of particles crossing the plate when the electromagnetic feedthrough is exposed to a sputtering source or the like. In a further variant, the microchannels may be curved. With this variant, particles moving on a straight line may be prevented from traversing the plate without hitting a wall of a recess. Light, or an other type of electromagnetic radiation, however, may either be reflected on a wall of a recess or enter into the material of the microchannel plate in case that the material is transparent. For any of the above variants, the microchannel plate may consist of glass. Similarly, an array of glass capillaries may provide the recess arrangement.

Microchannel plates, wherein the microchannels have a length to diameter ratio, which in this case corresponds to the depth to width ratio of the recesses, in the range of 40:1 to 80:1, may be produced according to method as sketched in the following. Raw material in the form of a glass tube and a soluble core are assembled by inserting the core into the bore of the glass tube. The core serves to prevent a disproportionate shrinking of the bore diameter in the subsequent drawing steps, but will be removed later, such that an open microchannel results. The assembled billet consisting of the glass tube and the core is drawn to a fiber in a first draw. A multiplicity of such fibers, or pieces of the fiber, are stacked, e.g. in a hexagonal arrangement. In a second draw, a multifilament fiber is drawn. Multifilament fibers in turn a stacked to an assembled capsule, which is then fused, cut into slices perpendicular to the orientation of the fibers, edge grinded and polished. An etching step then removes the cores and opens the microchannels. With a bending step applied to the assembled capsule before the slicing step, a microplate comprises curved microchannels may be produced.

In a variant of this embodiment, optionally a metallic layer may be provided on the inward facing surfaces of the capillaries forming the recess arrangement. This variant enables a way of operation, in which a repulsive electric potential may be established on said metallic layers. The potential being repulsive to ions that shall be kept away from the electromagnetic feedthrough. Depending on the process occurring the process chamber, the electric potential established on the metallic layer may have a fixed sign (positive or negative), or it may oscillate in a synchronous way with a voltage driving a plasma.

In an embodiment, surfaces of said window and/or surfaces of said recess arrangement and/or internal structures act together to have a lens effect on electromagnetic radiation, in particular light, originating from a source emitting electromagnetic radiation, in particular light, towards the first side of the optical feedthrough and crossing said optical feedthrough. In particular, a plano-concave lens, a plano-convex lens, a bi-concave lens, a bi-convex lens, a concave-convex lens, a Fresnel-lens, a metalense or a gradient index lens may be formed. An example for internal structures having a lens effect or contributing to a lens effect are variations in the refractive index. Such variations in the refractive index may be geometrically arranged and have a strength of variation such that a gradient index lens is formed.

A metalense uses planar surfaces consisting of sub-wavelength structures. These surfaces may be the top surfaces of pillars - called "nanopillars" in this context, as several adjacent pillars only cover a fraction of the wavelength - to manipulate light and provide a degree of control not possible with traditional refractive lenses. Alternatively, these surfaces may be formed by bottom surfaces of recesses formed into the window. In the latter case corresponds to a "negative" of the situation described as "nanopillars" above. Metasurface responses can be tuned for all properties of light including phase, wavelength, amplitude and polarization. Structuring the surfaces appropriately opens the possibility to focus light to a specific point on the second side of the optical feedthrough, e.g. to focus the electromagnetic radiation, in particular light, on a sensor, or even induce a spectral fanning out over an array of sensor, such that the optical feedthrough forms a part of a spectrometer. This latter variant may be combined with a vacuum pressure sensor of the cold cathode type described below.

In an embodiment, the one or more recesses of the recess arrangement have a form narrowing from an opening facing towards the first side to a bottom of the recess.

In this embodiment, the recesses have a conical or trumpet shaped form, with the larger opening on the first side. The large opening helps to collect a lot of light. The light paths then may be defined by multiple reflections on the wall of the recess. The light may then enter on the bottom of the recesses into the window material. This embodiment may be specifically robust against the effect of coating processes in the case, when reflecting layers are deposited. The optical feedthrough may have the reflecting property of the wall of the recess right from the beginning due to refractive index of the transparent material. The reflecting property may be conserved, in cases where a metallic layer or a dielectric layer is deposited in the entrance region of the recess.

In an embodiment, recesses of said recess arrangement are oriented each towards a common point spaced from said window on said first side.

In a simple case, the recesses may be oriented parallel to each other and essentially perpendicular to the window, **i.e.** be oriented towards a common point spaced far away. The common point towards which the recesses are oriented may be selected to be closer to the first side of the window, **e.g.** at a position, where in use, a plasma will be ignited and where light will be emitted. In this case, light starting from this common point can fall on the bottom of various recesses, and in all cases can travel on a straight line before it hits the bottom of the recess. This embodiment may be particularly useful in cases, in which coating with untransparent and non-reflecting coatings must be expected.

In an embodiment, the electromagnetic feedthrough comprises an electrically conductive element extending from said first side of said window, across said window to said second side of said window, and wherein a vacuum-tight connection between the window and said electrically conductive element is formed.

This embodiment may be implemented in conjunction with the vacuum pressure sensor of a cold cathode type, as discussed below in more detail. The electromagnetic feedthrough of this embodiment may in particular be an optical feedthrough. It may in particular be transparent to radiation in the visible range, in the ultraviolet range or the near-infrared range. The electromagnetic feedthrough may at the same time have the role of electrically insulating the said electrically conductive element from its surroundings, such that the electrically conductive element can be supplied with high voltage.

Furthermore, the invention is directed to a vacuum device according to claim 9. The vacuum device according to the invention comprises an electromagnetic feedthrough according to the invention. The electromagnetic feedthrough is arranged in a wall of the vacuum device. The electromagnetic feedthrough is connected along an outer rim of the electromagnetic feedthrough in a vacuum-tight manner to the sections of the wall adjacent to said electromagnetic feedthrough.

Optical windows for pressure chambers, e.g. in the form of standard viewports, may be built with the features of the electromagnetic feedthrough according to the present invention.

Further in the scope of the invention lies a vacuum pressure sensor according to claim 10. The vacuum pressure sensor according to the invention is of a cold cathode type. The vacuum pressure sensor comprises an electromagnetic feedthrough according to the invention. The electromagnetic feedthrough may in particular be an optical feedthrough, i.e. it may be transparent to radiation in the optical wavelength range. The vacuum pressure sensor comprises a cathode and an anode defining a measuring space in between them on the first side of the window. It further comprises a sensor for detecting light on the second side of the window. The vacuum pressure sensor is arranged such that light emitted from a plasma can enter through the recess arrangement into the window, traverse the window, exit from the window on the second side of the window and be detected by the sensor.

In a specific version of the vacuum pressure sensor, the optical feedthrough comprises an electrical feedthrough, realized as electrically conductive element traversing the window and being connected to the window in a vacuum-tight way. In this version, the electrically conducting element may for example be realized as central anode rod of a cold cathode pressure sensor of the inverted magnetron type. The central anode rod may be surrounded by a cathode of cylindrical or prismatic geometry. On a larger radius, outside the cathode, magnet elements may be arranged, such that a static magnetic field, which essentially is oriented parallel to the anode rod in the measuring space of the pressure sensor, helps to keep electrons on a curved path. In such a configuration, a plasma is ignited in the region around the anode rod. A relatively large amount of light emitted by the plasma then may fall onto the optical feedthrough surrounding the anode rod. In this position, the optical feedthrough is exposed to sputtering effects due to plasma. It profits from the effect of the feature combination of the present in that the bottom regions in the recesses will only be weakly affected by material deposition due to such a sputtering effect.

A further aspect of the present invention relates to a sensor arrangement according to claim 11. The inventive sensor arrangement is suitable for analyzing a status of a plasma in a processing chamber. The sensor arrangement comprises an electromagnetic feedthrough according to the present invention. It further comprises a sensor for measuring an electromagnetic field component in a wavelength region being transmittable across the electromagnetic feedthrough.

The sensor may be one of a light sensor, an infrared sensor an rf sensor or a magnetic field sensor. The sensor in the sensor arrangement may be arranged in proximity to the electromagnetic feedthrough, on the outside of the process chamber, in which - in use - the plasma to be monitored is ignited.

The invention shall now be further exemplified with the help of figures. The figures show:
Fig. 1 a schematic cross-sectional view of an embodiment of the electromagnetic feedthrough;
Fig. 2 a cut-away perspective view of a single recess;
Fig. 3 a cross-sectional view of a single recess of a specific embodiment;
Fig. 4, in sub-figures 4.a) to 4.d) variants of geometries of recess arrangements;
Fig. 5 a schematic cross-sectional view of an embodiment of the electromagnetic feedthrough in the context of a vacuum pressure sensor;
Fig. 6 a cross-section through an embodiment of the window with a recess arrangement;
Fig. 7 a cross-section through a further embodiment of the window with a variant of a recess arrangement;
Fig. 8 a cross-sectional and perspective view of a vacuum pressure sensor comprising an optical feedthrough;
Fig. 9 a cross-sectional and perspective view of elements of an embodiment of the electromagnetic feedthrough
Fig. 10 shows a cross-sectional view of a single recess after deposition of material;
Fig. 11 shows a schematic view of a process monitoring arrangement including the electromagnetic feedthrough;
Fig. 12 shows an embodiment of the feedthrough having the overall geometry of a conventional viewport, in

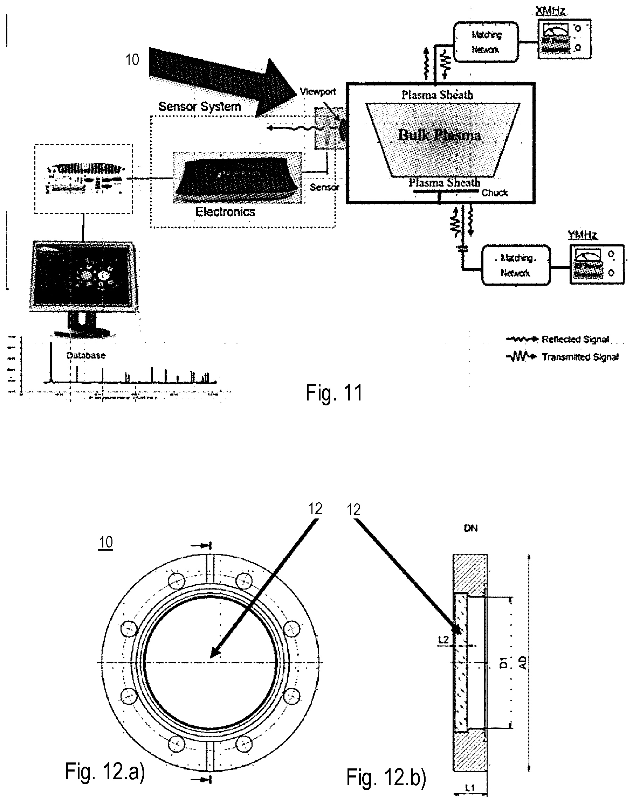

Fig. 12.a) in front view and in Fig. 12.b) in side view;

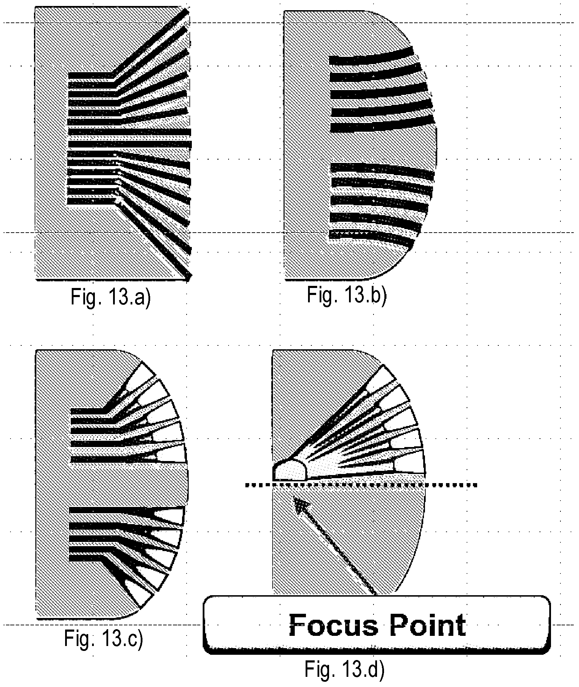

Fig. 13 shows in partial figures Fig. 13.a) to 13.d) cross-sections through embodiments of the window, displaying variants of lens designs and designs of the recesses in the recess arrangement.

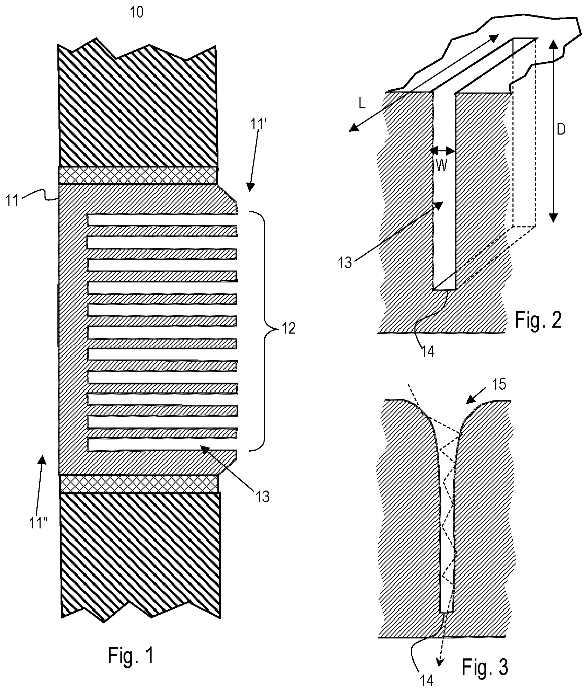

Fig. 1 shows schematically and simplified, a cross-section of the electromagnetic feedthrough. In the present example and some of the following examples, the specific case of an optical feedthrough is discussed, and the electromagnetic radiation is referred to as light. The optical feedthrough shown here comprises a window 11 made of an optically transparent material. The window material is indicated by diagonally hatched structures. The window in this embodiment is embedded into a wall structure, which may be opaque to light and sealed against the wallstructure. The window has a first side 11' and a second side 11'' facing away from the first side. A plurality of recesses is formed into the window, altogether being a recess arrangement 12. In the view shown here, every single cut through a recess 13 of the recess arrangement has a depth to width ratio larger than 10:1. The cross-section shown here may be a cross-section through a single recess having a spiral form, when looked at perpendicular to the first side of the window, i.e. in a direction parallel to the cutting plane and from the side right hand side in Fig. 1. The same cross-section may result from a multiplicity of recesses having the form of slits or of circular bores, as examples.

Fig. 2 explains the dimension of a specific case of a single recess 13. The recess has a width W, and a depth D. In the present figure the width is enlarged for easier identification of the features. According to the invention, the depth to width ratio D/W is larger than 10:1, preferably larger than 20:1. In the case shown here, the recess has the form of a slit, which extends into a direction perpendicular to the width and the depth over a length indicated as L, which length extends to both sides of the diagonally hatched cutting plane through the window material.

Fig. 3 shows a single recess of a specific embodiment. The recess is wider at an opening 15 than at a bottom 14 of the recess. The opening faces towards the first side of the window. In this embodiment, light may be collected in the whole area of the opening and be guided towards the bottom part, which is particularly well protected against material deposition. The light then traverses the window part between the bottom of the recess and the second side of the window, as indicated by a dashed line. In order to improve guiding the light towards the bottom of the recess, side walls of the recess may be made reflective. This may be achieved by an additional layer having a higher refractive index than the material of the window. Such a layer may be deposited in an atomic layer deposition (ALD) process. Such a layer, which increases the reflectivity may be deposited before the optical feedthrough is used for its definitive purpose. Alternatively, a layer, which increases the reflectivity of the side walls, may be produced as a side effect of the process, which shall be monitored by means of the optical feedthrough.

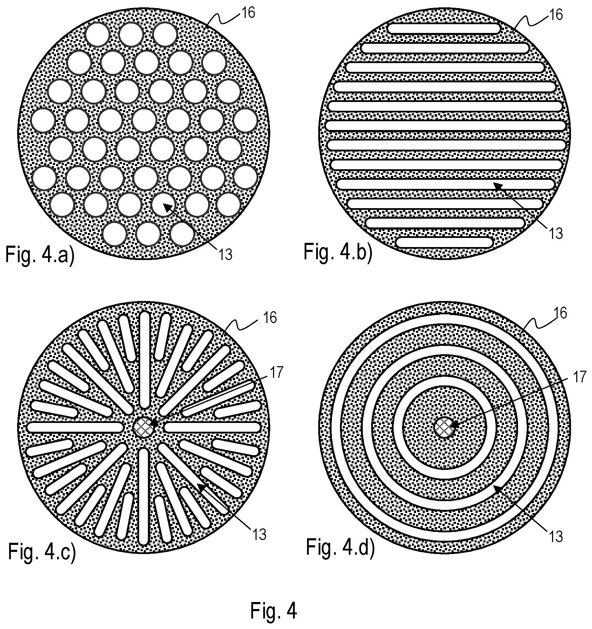

Fig. 4 shows variants of recess arrangements. In all cases shown, the regions shown in white correspond to the regions where the recesses are. The regions shown as dotted areas are the regions surrounding the recesses. These regions are much more exposed to material deposition or etching processes than the bottom of the recesses, which will stay for a much longer time transparent to light.

Fig. 4.a) shows an arrangement of recesses, wherein the individual recesses have the form of circular holes. The recesses are arranged in a densely packed hexagonal structure, such that the area covered by recesses is large. For illustrative purposes, the diameter of the bores is selected relatively large compared to the diameter of the window. This would require a large thickness of the whole window, in order to achieve a depth to width ration larger than 10:1. The diameter of the bores may however be chosen much smaller compared to the diameter of the window, such that hundreds or thousands of recesses cover the face of the window.

Fig. 4.b) shows an arrangement of recesses arranged in the form of parallel slits. Similar to the bores in Fig. 4.a), the slits may be much narrower, and the number may be factors higher than shown here. The slits shown here have rounded end, which prevents the occurrence of cracks in the window material.

Fig. 4.c) and 4.d) have in a central position an electrically conductive element 17 leading through the window, in such a way that an electro-optical feedthrough results. This electrically conductive element may **e.g.** play the role of a central anode in various practical applications, such as in a vacuum pressure sensor of the cold cathode type. Depending on other elements, such as for example the presence of a magnetic field forcing charged particles on paths spiraling around the central anode, a recess arrangement of radially oriented slits, such as shown in Fig. 4.c) may further be helpful to prevent that the bottom of the recesses is reached by the particles in a plasma. In cases where a radial movement of particles is expected, recesses may be oriented in such a way that their width is in a radial direction with respect to a center defined by the electrically conductive element. Such an orientation may e.g. be realized by recesses in the form of concentric rings, as shown in Fig. 4.d).

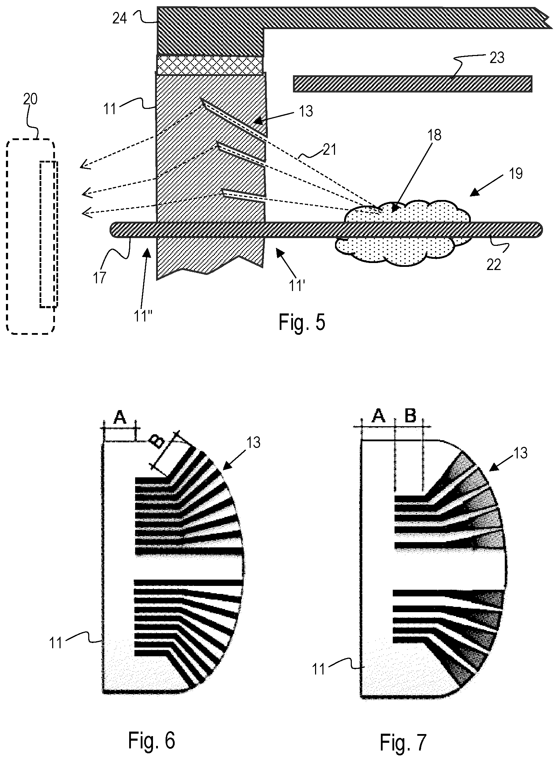

Fig. 5 illustrates the case of recesses oriented towards a common point 18. Such a point may be in the region, where a plasma is expected to be ignited in a measuring space between an anode 22 and a cathode 23 surrounding the anode. Light paths 21 then may fall along the recesses to the bottom of the recesses. The bottom of recesses may be oriented such that they, in combination, form a curved surface, such that the light is focused on the second side of the window. At this position, optionally an optical sensor 20 may be arranged, a possible position of which is indicated by dashed lines. In the variant illustrated in Fig. 5, the window is planar on the second side 11''. In further variants not shown in Fig. 5, also on the second side 11'', i.e. the atmosphere side, curved or tilted sections may be present as alternative or in addition to the structures on the first side 11'. As an example, the second side 11'' may form a concave or convex surface of a lens. As a further example not shown here, the grooves of a Fresnel lens or a micro Fresnel lens may be formed into the first side 11' and/or the second side 11'' of the window 11. As a further variant not visible in this Fig. 5, variations in the refractive index may be present such that a gradient index lens is formed. Furthermore, meta lenses may be formed. All these features may contribute to a focusing effect.

Fig. 6, Shows an optical window with high aspect structures integrated in to a lens. Dimension A denotes a minimal thickness required due to static pressure exerted onto the window during use. This may be the pressure difference between vacuum and an outside having atmospheric pressure. Dimension B may be adapted such that the aspect ratio of the recesses lies above 20:1, based on the diameter of the recess.

Fig. 7: Additional to figure 6 here the ends of the high aspect ratio structures are opened to avoid closing the holes under heavy deposition.

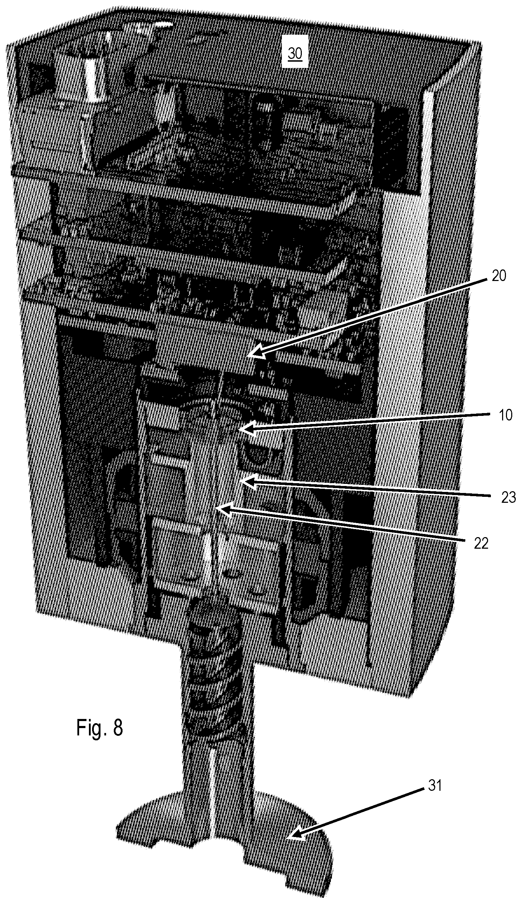

Fig. 8 shows a cross-section across a complete vacuum pressure sensor 30 of a cold cathode type. A measuring space is formed between an anode 22 in form of a central anode rod, and a cathode 23 surrounding the anode. The measuring space can be connected to a vacuum processing chamber by means of a vacuum flange 31. An optical feedthrough 10 according to the present invention is arranged between the measuring space and an optical sensor 20, which is arranged on the atmospheric side of the window. Details of the recess arrangement are not visible in this view, which only illustrates the position relative to the other elements of the vacuum pressure sensor. Above the optical sensor, electronic components are arranged on several prints.

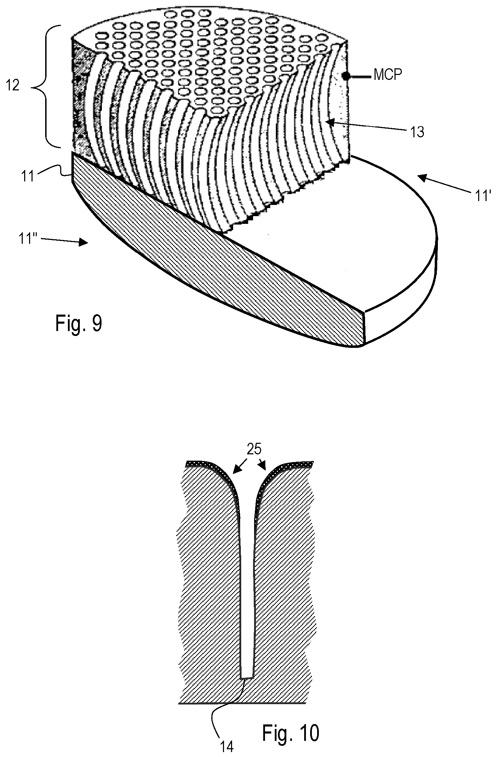

Fig. 9 shows two elements and their relative arrangement of an embodiment of the feedthrough. It is an embodiment according to the alternative, wherein the recess arrangement 12 is arranged adjacent to the window 11. In the specific variant shown here, a microchannel plate MCP is the part into which the recesses 13 are formed. The microchannel plate comprises in this case curved microchannels, each of which has a circular cross-section of a diameter much smaller than the length of the microchannels. The microchannel plate is shown in a cut-away view to illustrate the curved geometry of the channel inside the microchannel plate. The window 11 is in this variant formed as a plano-convex lens, wherein the planar side of the fits to a planar side of the microchannel plate. The window is shown in a cut-away view, too, to illustrate the plano-convex form of the lens.

Fig. 10 shows a single recess similar to the one shown in Fig. 3. Here, the situation after some material deposition is illustrated. Material deposition 25, here shown in black with white dots, has largest thickness on the part of the window facing to the first side - upwards in the present figure. The layer thickness of the deposited material is thinner inside the recess. Nearly nothing of the material arrives at the bottom 14 of the recess, such that electromagnetic radiation, specifically light, may still traverse the window part of the optical feedthrough. A closing of the recess due to deposited material is prevented or significantly delayed by this geometry of the recess.

Fig. 11 displays a process monitoring arrangement including the electromagnetic feedthrough 10. A large arrow points to its position in the wall of a process chamber. In this case it has the role of a viewport, as well. A bulk plasma is created inside the process chamber by applying an rf power of X MHz and by applying an rf power of Y MHz on the chuck side of the processing chamber. Both rf power supplies are connected to the electrodes on the plasma side through a matching network. The rf power supplies may e.g. provide rf power in a frequency range from 1 MHz to 1 GHz. In vacuum processing techniques, a frequency of 13.5 MHz may be particularly suitable. In general, it is of interest to transmit all the rf power into the plasma, i.e. to minimize the reflected power by adjusting the impedance of the matching network. A sensor arranged directly outside the electromagnetic feedthrough, which may have the overall geometry shown in Fig. 12 below, is configured to detect rf signals exiting through the electromagnetic feedthrough. The detecting signal then is processed through several steps, such that it can be analyzed in a computer. The process steps may include pre-amplification, filtering, analog-to-digital conversion and Fourier transformation. The result may then be compared to signals stored in a database. From this comparison, one can confer in which status the plasma is and whether changes of the process parameters are appropriate. In this situation it is helpful that the fields detected by the sensor do not change excessively depending on the amount of material deposited on the side, which faces towards the plasma.

Fig. 12 shows an embodiment of the feedthrough having the overall geometry of a conventional viewport, in Fig. 12.a) in front view and in Fig. 12.b) in side view. The recesses of the recess arrangement 12 are not visible in this figure. The arrow with the reference sign 12 points to the window, into which the recess arrangement is fabricated, e.g. by selective laser etching. The recess arrangement may have a structure as shown in any of the subfigures of Fig. 4.

Fig. 13 shows in partial figures Fig. 13.a) to 13.d) cross-sections through embodiments of the window, displaying variants of lens designs and designs of the recesses in the recess arrangement. Fig. 13.a) shows a variant, in which both sides of the window are planar. Figs. 13.b) to 13.d) show variants of plano-convex lenses, wherein the convex side is the first side, i.e. it faces in use towards the processing side. Figs. 13.a) and 13.c) show variants with sharp changes of direction, as may be produced by selective laser etching. This recess geometry is particularly adapted to protect the bottom of recess from direct bombardment by atoms or ions travelling on straight lines. Fig. 13.b) shows a variant of slightly bending recesses. This recess geometry is particularly adapted to guiding light along the bent form. Figs. 13.c) and 13.d) show variants in which the opening of the recesses is relatively large and in which the recess becomes narrower closer to their bottom. This recess geometry has the advantage illustrated in Fig. 10, namely that a decrease of the cross-section due to material deposition occurs mainly in the part with the widest cross-section. Fig. 13.d) shows a variant, where several recesses of the recess arrangement lead towards a common focus point or a common focus region. The focus region may be a hollow part, being free of material, or, alternatively, be a region of modified material properties, such as a modified refractive index compared to the rest of the window.

### List of reference signs

- 10: optical feedthrough
- 11: window
- 11': first side (of the window)
- 11": second side (of the window)
- 12: recess arrangement
- 13: recess (with high depth to width ratio)
- 14: bottom (of recess)
- 15: opening (of recess)
- 16: area not covered by recess arrangement
- 17: electrically conductive element
- 18: common point (defining orientation of recesses)
- 19: plasma
- 20: optical sensor
- 21: light path
- 22: anode
- 23: cathode
- 24: wall
- 25: material deposition
- 30: vacuum pressure sensor
- 31: vacuum flange
- A: dimension of part of window without recesses
- B: depth of part of recess
- D: depth
- W: width
- L: length
- MCP: microchannel plate

## Claims

1. Electromagnetic, in particular optical, feedthrough (10) for guiding electromagnetic radiation, in particular light, out of a processing chamber, wherein said electromagnetic feedthrough comprises a window (11) made of a material transparent to an electromagnetic radiation, in particular transparent to radiation in the optical range, wherein the window has a first side (11') intended to face towards a source electromagnetic radiation, in particular towards a source of light, and a second side (11") facing away from said first side, wherein on said first side a recess arrangement (12) is formed into the window or a recess arrangement is arranged adjacent to the window, said recess arrangement comprising at least one recess (13) with a depth to width ratio larger than 10:1, preferably larger than 20:1, preferably wherein said recess arrangement comprises a multitude of recesses all having a depth to width ratio larger than 10:1, preferably larger than 20:1.

2. Electromagnetic feedthrough according to claim 1, wherein, in a view direction from the first side, a percentage of the area of the window covered by said recess arrangement is larger than 50%.

3. Electromagnetic feedthrough according to claim 1 or 2, wherein the recesses (13) of said recess arrangement (12) are formed by selective laser-induced etching, in particular, wherein said recesses are formed into the window.

4. Electromagnetic feedthrough according to claim 1 or **2,** wherein said recess arrangement is arranged before the window and wherein the recess arrangement is a microchannel plate (MCP) or an array of glass capillaries.

5. Electromagnetic feedthrough according to any one of claims 1 to 4, wherein surfaces of said window and/or surfaces of said recess arrangement and/or internal structures act together to have a lens effect on electromagnetic radiation, in particular on light, originating from a source emitting electromagnetic radiation, in particular light, towards the first side of the optical feedthrough and crossing said optical feedthrough, in particular, wherein a plano-concave lens, a plano-convex lens, a bi-concave lens, a bi-convex lens, a concave-convex lens, a Fresnel-lens, a metalens or a gradient index lens is formed.

6. Electromagnetic feedthrough according to any one of claims 1 to 5, wherein the recesses of said recess arrangement have a form narrowing from an opening (15) facing towards said first side to a bottom (14) of the recess.

7. Electromagnetic feedthrough according to any one of claims 1 to 6, wherein recesses of said recess arrangement are oriented each towards a common point (18) spaced from said window on said first side.

8. Electromagnetic feedthrough according to any one of claims 1 to 7, wherein the electromagnetic feedthrough comprises an electrically conductive element (17) extending from said first side of said window, across said window to said second side of said window, and wherein a vacuum-tight connection between said window and said electrically conductive element is formed.

9. Vacuum device comprising, arranged in a wall (24) of said vacuum device, an electromagnetic feedthrough (10) according to any one of claims 1 to 8, wherein said feedthrough is connected along an outer rim of the optical feedthrough in a vacuum-tight manner to the sections of the wall adjacent to said optical feedthrough.

10. Vacuum pressure sensor (30) of a cold cathode type, wherein the vacuum pressure sensor comprises an electromagnetic feedthrough (10) according to any one of claims 1 to 8, a cathode (23) and an anode (22) defining a measuring space in between them on said first side of said window, a sensor (20) for detecting light on said second side of said window, wherein the vacuum pressure sensor is arranged such that light emitted from a plasma can enter through the recess arrangement into said window, traverse said window, exit from said window on said second side of said window and be detected by said sensor.

11. Sensor arrangement for analyzing a status of a plasma in a processing chamber, wherein the sensor arrangement comprises an electromagnetic feedthrough according to any one of claims 1 to 8, wherein the sensor arrangement further comprises a sensor for measuring an electromagnetic field component in a wavelength region being transmittable across the electromagnetic feedthrough.
